# EUROPEAN PATENT SPECIFICATION

(11) **EP 0 878 907 B1**
(45) Date of publication and mention of the grant of the patent: **08.09.2004**
(21) Application number: 98108506.1
(22) Date of filing: 11.05.1998
(51) Int. Cl.: H03K 3/84

(54) **Random number generator arrangement and method of generation thereof**
Zufallszahlengenerator-Anordnung und Verfahren zu deren Erzeugung
Montage générateur de nombres aléatoires et procédé de génération correspondant

(30) Priority: 16.05.1997 GB 9710056
(43) Date of publication of application: 18.11.1998
(73) Proprietor: MOTOROLA, INC., Schaumburg, IL 60196 (US)
(72) Inventor: Stout, Graham, Giffnock, Glasgow, Scotland G46 6PP (GB); Lin, Bo, Stewartfield, East Kilbride (GB); Mcallister, Stephen, Greenhills, East Kilbride, Glasgow (GB)
(74) Representative: Gibson, Sarah Jane

(56) References cited:
- EP-B- 0 258 432
- DE-C- 19 618 098
- US-A- 3 810 039
- US-A- 3 986 136
- US-A- 4 318 008
- US-A- 5 007 087

## Description

### FIELD OF THE INVENTION

This invention relates generally to random number generation.

### BACKGROUND OF THE INVENTION

Random number generation is required in a range of applications, and particularly though not exclusively in security applications where a random number is used in the generation of an encoding or encryption key. As used herein, it is to be understood that the term random number covers both numbers which are truly or mathematically random as well as numbers which approximate to or have a degree of randomness (typically called pseudo random numbers).

It is well known that a random number generator can be designed by cascading two or more independent oscillators. This can be done in software or in hardware.

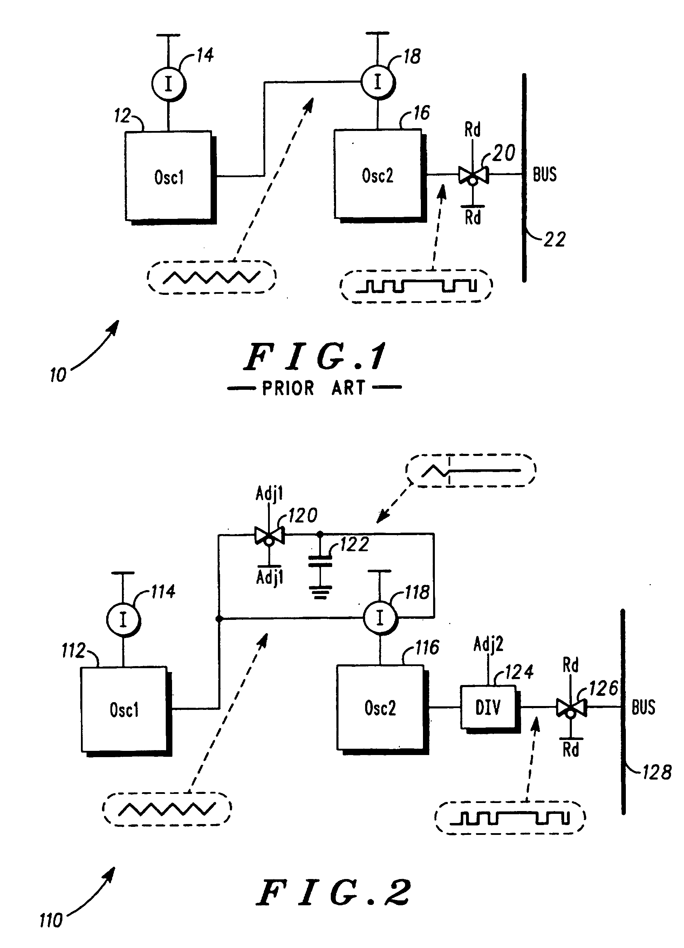

Referring now to FIG. 1 of the accompanying drawings, in a typical hardware implementation of a cascaded-oscillator random number generator circuit 10 a first oscillator 12 is a relaxation oscillator which charges and discharges a capacitor (not shown) from a first, fixed current source 14 to produce a saw-tooth waveform output at a first frequency. A second oscillator 16 is also a relaxation oscillator which charges and discharges a capacitor (not shown) from a second, voltage-controlled current source 18. The second current source 18 which supplies the second oscillator 16, is modulated by the saw-tooth waveform output from the first oscillator 12. The output of the second oscillator 16 is thus a pulse train representing a random number which is gated, via a transmission gate 20 controlled by a read signal Rd, onto a data bus 22.
EP 0 258 432 B1 discloses a pseudorandom noise generator that is arranged to operate in either a low inde of modulation of a high index of modulation.

It has been realised that in practice certain factors may reduce the randomness of the number produced by the circuit of FIG. 1. For example, the frequencies of the first and second oscillators will vary with variations in supply voltage and temperature. Thus, although the circuit output will be generally non-periodic, it may be possible to find a voltage where the oscillators "beat" in harmony, resulting in a periodic output.

### SUMMARY OF THE INVENTION

It is an object of the present invention to provide a random number generator arrangement and method of generation thereof in which the above disadvantages are overcome or at least alleviated.

In accordance with a first aspect of the invention there is provided a random number generator arrangement as claimed in claim 1.

In accordance with a second aspect of the invention there is provided a method of generating a random number as claimed in claim 8.

### BRIEF DESCRIPTION OF THE DRAWINGS

One random number generator arrangement and method of generation thereof will now be described, by way of example only, with reference to the accompanying drawings, in which:
FIG. 1 shows a block schematic diagram of a random number generator arrangement known in the prior art; and
FIG. 2 shows a random number generator arrangement incorporating the present invention.

### DETAILED DESCRIPTION OF A PREFERRED EMBODIMENT

Referring now to FIG. 2 of the accompanying drawings, a cascaded-oscillator random number generator 110 includes a first relaxation oscillator 112 which charges and discharges a capacitor (not shown) from a first, fixed current source 114 to produce a saw-tooth waveform output at a first frequency. A second relaxation oscillator 116 charges and discharges a capacitor (not shown) from a second, voltage-controlled current source 118. The second current source 118 is coupled at a first control input directly to the output of the first oscillator 112 to be modulated by the saw-tooth waveform output thereof. As will be discussed further below, the output of the first oscillator 112 is also coupled to a second control input of the second current source 118 via a transmission gate 120, which is controlled by the state of a software settable data bit (not shown), which controls an adjust signal Adj1. A storage capacitor 122 is connected between ground and a point between the transmission gate 120 and the second current source 118.

The output of the second oscillator 116 is coupled through a divider 124 and a transmission gate 126 (controlled by a read signal Rd) onto a data bus 128. The divide ratio of the divider 124 is selectable between unity and a predetermined, non-unity value by the state of a software settable data bit (not shown), which controls an adjust signal Adj2.

The random number generator 110 allows a user to select one of four settings of the two adjust bits described above to adjust the randomness of the random number produced thereby.

The adjustment bit which controls the divider 124 determines whether the output pulse train from the second oscillator 116 is divided by a predetermined ratio before being gated onto the data bus 128. It will be appreciated that such division of the output pulse train from the second oscillator 116 further 'randomises' the resultant number.

The adjustment bit which controls the transmission gate 120 acts as follows to 'randomise' the resultant number in a more fundamental way. The transmission gate 120 and the storage capacitor 122 allow the user to adjust the second current source 118 by an analogue value determined by the point in time when the output saw-tooth waveform from the first oscillator 112 is sampled and held upon closure of the transmission gate 120. The user adjusts the randomness of the resultant number by 'blipping' or 'pulsing' the adjustment bit for the transmission gate 120 (i.e., setting the adjustment bit to a value, say '0' to open the transmission gate 120, then waiting for a predetermined time - set in software - before setting the adjustment bit to the opposite value, say '1', to close the transmission gate 120 and leave the sampled value of the output saw-tooth waveform from the first oscillator 112 at that instant stored on the capacitor 122). Thus, 'blipping' or 'pulsing' the adjust bit for the transmission gate 120 adds an amount of extra current to the second oscillator (and so changes its frequency) by an amount (between minimum and maximum values of the output saw-tooth waveform from the first oscillator 112) determined by the instant at which the transmission gate 120 is closed.

Thus, in order to obtain increased randomisation, the user 'blips' or 'pulses' the adjustment bit for the transmission gate 120 immediately before reading a random number from the random number generating arrangement 110.

It will be understood that because the frequency of the output saw-tooth waveform from the first oscillator 112 will typically vary with manufacturing process variations, with operating temperature changes and with operating voltage changes, and because the switching time of the transistors forming the transmission gate 120 will vary for the same reasons, the exact analogue value sampled and held on the storage capacitor 122 will not be predictable in practice. Further, it will be understood that the exact effect of this analogue value on changing the current produced by the current source 118 will also vary with manufacturing process variations, with operating temperature changes and with operating voltage changes to the transistors forming the current source 118. As a result of these compounded unpredictabilities, it will be appreciated that the exact effect of the adjustment caused such 'blipping' or 'pulsing' is highly unpredictable, and that such 'blipping' or 'pulsing' therefore considerably increases the randomness of the resultant random number.

Practical analysis and testing of the arrangement of FIG. 2 has confirmed that the 'blipping' or 'pulsing' described produces a significant increase in randomness.

It will be appreciated that the first oscillator 112 may produce a varying waveform other than the saw-tooth waveform described (for example a continuously varying waveform such as a sine wave), but that periods of constancy in the waveform with may reduce the effectiveness of the increased randomisation produced by 'blipping' or 'pulsing' the adjustment bit for the transmission gate 120.

## Claims

1. A random number generator arrangement comprising:
first oscillator means for producing a varying waveform output signal at a first frequency;
second oscillator means, coupled to the output of the first oscillator means so that the frequency of the second oscillator means is controlled by the output of the first oscillator means, for producing a pulse train output representative of a random number,
**characterised by**
software settable adjustment means coupled between the output of the first oscillator means and the second oscillator means for randomly adjusting the frequency of the second oscillator means.

2. A random number generator arrangement according to claim 1 wherein the second oscillator means includes a current source which is coupled to the output of the first oscillator means, and the adjustment means comprises storage means for storing the value of the output of the first oscillator means at a chosen time and for applying the stored value to the current source so that the frequency thereof is controlled by the combination of the output of the first oscillator means and the stored value.

3. A random number generator arrangement according to claim 2 wherein the storage means comprises a capacitor coupled to the output of the first oscillator means by a switch.

4. A random number generator arrangement according to claim 3 wherein the opening and closing of the switch is controlled by the value of a software settable data bit.

5. A random number generator arrangement according to any preceding claim further comprising means for selectably dividing the output from the second oscillator means.

6. A random number generator arrangement according to claim 5 wherein the division ratio of the divider means is controlled by the value of a software settable data bit.

7. A random number generator arrangement according to any preceding claim wherein the varying waveform produced by the first oscillator means is a substantially saw-tooth waveform.

8. A method of generating a random number comprising the steps of:
driving first oscillator means to produce a varying waveform output signal at a first frequency;
driving second oscillator means, coupled to the output of the first oscillator means so that the frequency of the second oscillator means is controlled by the output of the first oscillator means, to produce a pulse train output representative of a random number,
**characterised by**
sampling the output of the first oscillator means at a software settable chosen point in time and randomly adjusting the frequency of the second oscillator means by applying thereto the sampled value.

## Patentansprüche

1. Zufallszahlengeneratoranordnung, die umfasst:
erste Oszillatormittel zum Erzeugen eines variierenden Wellenformausgangssignals bei einer ersten Frequenz;
zweite Oszillatormittel, die mit dem Ausgang der ersten Oszillatormittel gekoppelt sind, so dass die Frequenz der zweiten Oszillatormittel durch den Ausgang der ersten Oszillatormittel gesteuert wird, zum Erzeugen einer Impulsfolgenausgabe, die eine Zufallszahl darstellt,
**gekennzeichnet durch**
**durch** Software einstellbare Einstellmittel, die zwischen dem Ausgang der ersten Oszillatormittel und der zweiten Oszillatormittel gekoppelt sind, zum zufälligen Einstellen der Frequenz der zweiten Oszillatormittel.

2. Zufallszahlengeneratoranordnung gemäß Anspruch 1, wobei die zweiten Oszillatormittel eine Stromquelle umfassen, die mit dem Ausgang der ersten Oszillatormittel gekoppelt ist, und die Einstellmittel Speichermittel zum Speichern des Wertes der Ausgabe der ersten Oszillatormittel bei einer ausgewählten Zeit und zum Abliefern des gespeicherten Wertes an die Stromquelle umfassen, so dass deren Frequenz durch die Kombination der Ausgaben der ersten Oszillatormittel und des gespeicherten Werts gesteuert wird.

3. Zufallszahlengeneratoranordnung gemäß Anspruch 2, wobei die Speichermittel einen Kondensator umfassen, der mit dem Ausgang der ersten Oszillatormittel durch einen Schalter gekoppelt ist.

4. Zufallszahlengeneratoranordnung gemäß Anspruch 3, wobei das Öffnen und Schließen des Schalters durch den Wert eines durch Software einstellbaren Datenbits gesteuert wird.

5. Zufallszahlengeneratoranordnung gemäß einem beliebigen der vorhergehenden Ansprüche, die weiterhin Mittel zum auswählenden Teilen der Ausgabe aus den zweiten Oszillatormitteln umfasst.

6. Zufallszahlengeneratoranordnung gemäß Anspruch 5, wobei das Teilungsverhältnis der Teilermittel durch den Wert eines durch Software einstellbaren Datenbits gesteuert wird.

7. Zufallszahlengeneratoranordnung gemäß einem beliebigen der vorhergehenden Ansprüche, wobei die durch die ersten Oszillatormittel erzeugte variierende Wellenform im Wesentlichen eine Sägezahlwellenform ist.

8. Verfahren zum Erzeugen einer Zufallszahl, das die folgenden Schritte umfasst:
Treiben erster Oszillatormittel, um ein variierendes Wellenformausgangssignal bei einer ersten Frequenz zu erzeugen;
Treiben zweiter Oszillatormittel, die mit dem Ausgang der ersten Oszillatormittel gekoppelt sind, so dass die Frequenz der zweiten Oszillatormittel durch die Ausgabe der ersten Oszillatormittel gesteuert wird, um eine Impulsfolgenausgabe zu erzeugen, die eine Zufallszahl darstellt,
**gekennzeichnet durch**
Abtasten der Ausgabe der ersten Oszillatormittel zu einem **durch** Software einstellbaren ausgewählten Zeitpunkt und zufälliges Einstellen der Frequenz der zweiten Oszillatormittel **durch** Anwenden des abgetasteten Wertes auf die zweiten Oszillatormittel.

## Revendications

1. Agencement générateur de nombre aléatoire comprenant :
des premiers moyens formant oscillateur pour produire un signal de sortie de forme d'onde variable, à une première fréquence ;
des deuxièmes moyens formant oscillateur, couplés à la sortie des premiers moyens formant oscillateur de telle sorte que la fréquence des deuxièmes moyens formant oscillateur soit commandée par la sortie des premiers moyens formant oscillateur, pour produire une sortie à train d'impulsions représentative d'un nombre aléatoire ;
**caractérisé par** :
des moyens d'ajustement réglables par logiciel, couplés entre la sortie des premiers moyens formant oscillateur et les deuxièmes moyens formant oscillateur, pour ajuster de manière aléatoire la fréquence des deuxièmes moyens formant oscillateur.

2. Agencement générateur de nombre aléatoire selon la revendication 1, dans lequel les deuxièmes moyens formant oscillateur comprennent une source de courant qui est couplée à la sortie des premiers moyens formant oscillateur, et les moyens d'ajustement comprennent des moyens de stockage destinés à stocker la valeur de la sortie des premiers moyens formant oscillateur, à un instant choisi, et à envoyer la valeur stockée à la source de courant, de telle sorte que la fréquence de cette dernière soit commandée par la combinaison de la sortie des premiers moyens formant oscillateur et de la valeur stockée.

3. Agencement générateur de nombre aléatoire selon la revendication 2, dans lequel les moyens de stockage comprennent un condensateur couplé à la sortie des premiers moyens formant oscillateur par un interrupteur.

4. Agencement générateur de nombre aléatoire selon la revendication 3, dans lequel l'ouverture et la fermeture de l'interrupteur sont commandées par la valeur d'un bit de données réglable par logiciel.

5. Agencement générateur de nombre aléatoire selon l'une quelconque des revendications précédentes, comprenant, en outre, des moyens servant à diviser d'une manière sélectionnable la sortie des deuxièmes moyens formant oscillateurs.

6. Agencement générateur de nombre aléatoire selon la revendication 5, dans lequel le rapport de division des moyens diviseurs est commandé par la valeur d'un bit de données réglable par logiciel.

7. Agencement générateur de nombre aléatoire selon l'une quelconque des revendications précédentes, dans lequel la forme d'onde variable produite par les premiers moyens formant oscillateur est une forme d'onde essentiellement en dents de scie.

8. Procédé de génération d'un nombre aléatoire, comprenant les étapes qui consistent à :
attaquer les premiers moyens formant oscillateur de manière à produire un signal de sortie à forme d'onde variable, à une première fréquence ;
attaquer les deuxièmes moyens formant oscillateur, couplés à la sortie des premiers moyens formant oscillateur, de telle sorte que la fréquence des deuxièmes moyens formant oscillateur soit commandée par la sortie des premiers moyens formant oscillateur, pour produire une sortie à train d'impulsions représentative d'un nombre aléatoire,
**caractérisé par** les étapes qui consistent à :
échantillonner la sortie des premiers moyens formant oscillateur à un instant choisi, réglable par logiciel, et ajuster de manière aléatoire la fréquence des deuxièmes moyens formant oscillateur en leur envoyant la valeur échantillonnée.
